# EUROPÄISCHE PATENTSCHRIFT

(11) **EP 0 649 180 B1**
(45) Veröffentlichungstag und Bekanntmachung des Hinweises auf die Patenterteilung: **08.07.1998**
(21) Anmeldenummer: 94114013.9
(22) Anmeldetag: 07.09.1994
(51) Int. Cl.: H01P 1/19, H03J 3/16

(54) **Streifenleitung mit abstimmbarer elektrischer Länge**
Stripline with adjustable electrical length
Ligne à bande avec une longueur électrique réglable

(30) Priorität: 14.10.1993 DE 4334977
(43) Veröffentlichungstag der Anmeldung: 19.04.1995
(73) Patentinhaber: AFT Advanced Ferrite Technology GmbH, 71522 Backnang (DE)
(72) Erfinder: Arnold, Wolfgang, Dr., D-71546 Aspach (DE); Weiser, Wolfgang, D-71546 Aspach (DE); Pivit, Erich, Dr., D-71573 Allmersbach i.T. (DE); Martin, Siegbert, D-71570 Oppenweiler (DE)

(56) Entgegenhaltungen:
- EP-A- 0 429 791
- IBM TECHNICAL DISCLOSURE BULLETIN., Bd.2, Nr.6, April 1960, NEW YORK US Seiten 108 - 109 C.O.L. KINBERG ET AL. 'Non-linear controllable transmission lines'

## Beschreibung

Die vorliegende Erfindung betrifft eine Streifenleitung, deren elektrische Länge mit Hilfe eines variablen Vormagnetisierungsfeldes abstimmbar ist, das auf Ferrit einwirkt, mit dem ein streifenförmiger Innenleiter und/oder ein diesen umgebender Außenleiter zumindest teilweise belegt ist.

Eine derartige Streifenleitung ist aus EP-A-429 791 bekannt. Da ihre elektrische Länge veränderbar ist, kann sie beispielsweise zur Abstimmung von Resonatoren verwendet werden. Da eine solche Streifenleitungs-Abstimmvorrichtung, wie aus der EP-A-429 791 hervorgeht, wegen ihrer geringen Verluste und sehr guten Kühlmöglichkeiten mit sehr hohen Leistungen betrieben werden kann, erweist sie sich als vorteilhaft für den Einsatz in Teilchenbeschleunigern.

Die bekannte in ihrer elektrischen Länge abstimmbare Streifenleitung ist einem Vormagnetisierungsfeld ausgesetzt, das einen statischen und einen variablen Anteil aufweist. Das von einem Permanentmagnet erzeugte statische Vormagnetisierungsfeld ist so groß, daß das Ferrit in der Streifenleitung bis zur Sättigung vormagnetisiert ist. Dann wird nämlich das Ferrit verlustfrei, und bei weiterer Steigerung des Vormagnetisierungsfeldes können die Mikrowelleneigenschaften des Ferrits so beeinflußt werden, daß sich die elektrische Länge der Streifenleitung ändert. Der variable Anteil des Vormagnetisierungsfeldes wird gemäß dem Stand der Technik von einem Elektromagneten erzeugt.

Ein Nachteil der bekannten Anordnung besteht darin, daß das veränderbare Vormagnetisierungsfeld außerhalb der Streifenleitung erzeugt wird. Denn damit das Feld im Ferrit wirksam werden kann, muß es den Außen- und Innenleiter der symmetrischen Streifenleitung durchdringen. Da Außen- und Innenleiter aus leitendem Material bestehen, verhindern sie durch Wirbelströme ein schnelles Eindringen des Magnetfeldes in das Ferritmaterial. Die Abstimmgeschwindigkeit der Streifenleitung wird so durch Wirbelströme begrenzt. Z.B. beträgt die Grenzfrequenz für die Abstimmung bei einer Streifenleitung, dessen als Außenleiter dienendes Gehäuse aus Messing mit einer Wandstärke von 2 mm besteht, ca. 25 Hz. Die Abstimmungs-Grenzfrequenz könnte z.B. durch die Verwendung von Edelstahl für das Gehäuse auf ca. 800 Hz erhöht werden.

Durch Verringerung der Wandstärke des Gehäuses könnte die Grenzfrequenz auch weiter gesteigert werden. Dieser Möglichkeit sind aber durch die geforderte mechanische Stabilität der Anordnung Grenzen gesetzt.

Allenfalls die Reduzierung der Wirbelströme könnte noch eine Verbesserung der Grenzfrequenz mit sich bringen. Durch Schlitze im Gehäuse können die Wirbelstrombahnen unterbrochen werden. Es ist aber dabei zu beachten, daß die Schlitze parallel zu den Strombahnen des Hochfrequenzfeldes der Streifenleitung verlaufen, um die Hochfrequenzströme nicht zu unterbrechen, was zur Energieabstrahlung führen würde.

Es hat sich gezeigt, daß alle die genannten Maßnahmen bei einer abstimmbaren Streifenleitung gemäß dem Stand der Technik allenfalls eine Abstimmungsgrenzfrequenz von ca. 2 kHz ermöglichen.

Der Erfindung liegt nun die Aufgabe zugrunde, eine Streifenleitung der eingangs genannten Art anzugeben, deren elektrische Länge mit möglichst hoher Geschwindigkeit veränderbar ist.

Erfindungsgemäß wird diese Aufgabe durch die Merkmale des Anspruchs 1 gelöst. Zweckmäßige Weiterbildungen der Erfindung gehen aus den Unteransprüchen hervor.

Nach der Erfindung werden Außen- und Innenleiter der Streifenleitung mit zur Erzeugung eines veränderbaren Vormagnetisierungsfeldes herangezogen. Dieses braucht daher nicht das Außenleiter-Gehäuse zu durchdringen, so daß darin auch keine die Abstimmungsgrenzfrequenz beschränkenden Wirbelströme entstehen können.

Anhand eines in der Zeichnung dargestellten Ausführungsbeispiels wird nachfolgend die Erfindung näher erläutert. Es zeigen:
Fig. 1 eine perspektivische Darstellung einer Streifenleitung gemäß dem Stand der Technik,
Fig. 2 eine Draufsicht auf eine geschlitzte Streifenleitung,
Fig. 3 einen Querschnitt A-A durch die geschlitzte Streifenleitung und
Fig. 4 die geschlitzte Streifenleitung mit einem Permanentmagneten und einem Elektromagneten.

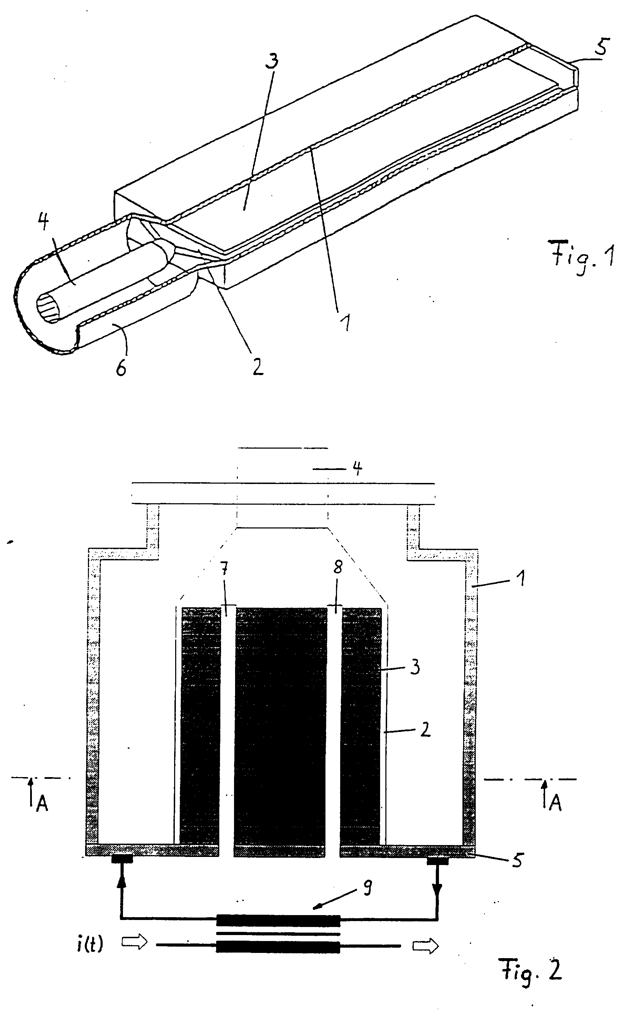

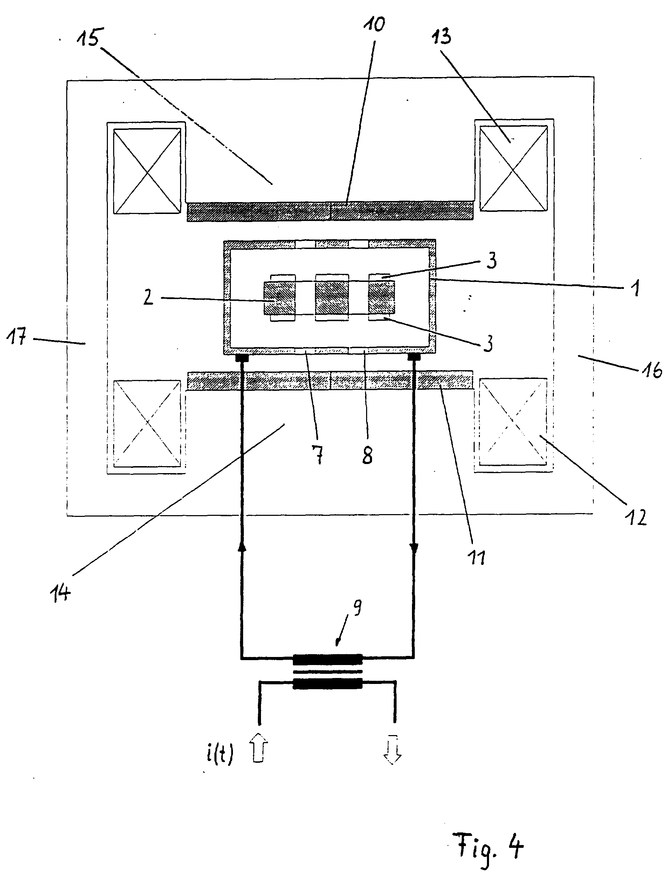

In der Fig. 1 ist eine symmetrische Streifenleitung gemäß dem Stand der Technik dargestellt, bestehend aus einem als Außenleiter dienenden Gehäuse 1 (teilweise aufgeschnitten gezeichnet) und einem darin angeordneten planaren Innenleiter 2. Ein Ende der Streifenleitung geht auf einen Koaxialleiter über, dessen Außenleiter 6 mit dem Gehäuse 1 und dessen Innenleiter 4 mit dem planaren Innenleiter 2 verbunden ist. Der Koaxialleiter 6, 4 stellt die Verbindung der Streifenleitung 1, 2 z.B. mit einem abzustimmenden Resonator her. An dem der Koaxialleitung 6, 4 gegenüberliegenden Ende ist die Streifenleitung 1, 2 mit einer Kurzschlußplatte 5 versehen, die Außen- und Innenleiter 1, 2 miteinander kontaktiert. Beide Seiten des planaren Innenleiters 2 sind mit Ferrit 3 belegt. Abweichend vom gezeichneten Ausführungsbeispiel, kann Ferrit zusätzlich oder ausschließlich an den Innenseiten des Außenleiters 1 aufgebracht sein. Zur Kühlung des Ferrits 3 ist es zweckmäßig, im Innen- 2 und/oder Außenleiter 1 Kühlkanäle (nicht dargestellt) vorzusehen.

Wie bereits einleitend gesagt, wird das Ferrit 3 einem Vormagnetisierungsfeld ausgesetzt, das sich aus einem von einem Permanentmagneten erzeugten statischen Magnetfeld und einem diesem überlagerten variablen, die elektrische Länge der Streifenleitung steuernden Magnetfeld zusammensetzt.

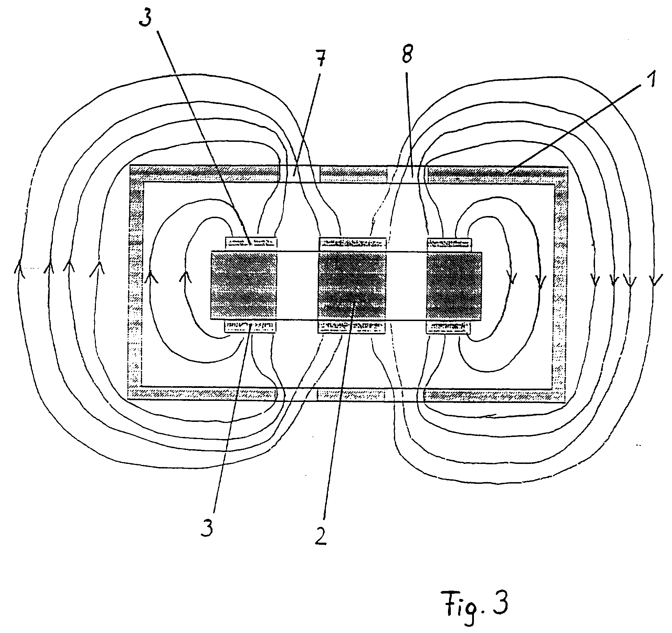

Das variable Vormagnetisierungsfeld wird mittels eines veränderbaren Stromes erzeugt, der Außen- 1 und Innenleiter 2 der Streifenleitung durchfließt. Zu diesem Zweck ist die in Fig. 1 dargestellte bekannte Streifenleitung folgendermaßen verändert worden. Eine Draufsicht auf die Streifenleitung in Fig. 2 und ein Querschnitt A-A durch die Streifenleitung in Fig. 3 verdeutlichen, daß sie mit zwei in Wellenausbreitungsrichtung verlaufenden Schlitzen 7 und 8 versehen ist, die sowohl den Außenleiter 1 als auch den Innenleiter 2 einschließlich der Kurzschlußplatte 5 durchtrennen. Die beiden Schlitze 7 und 8 enden vor dem Übergang von der Streifenleitung 1, 2 auf die Koaxialleitung 6, 4. Durch die zwei Schlitze 7, 8 entstehen zwei äußere Streifenleitungsabschnitte und ein mittlerer Abschnitt. Speist man nun in einen der beiden äußeren Abschnitte einen Strom i(t) ein, der über den anderen äußeren Abschnitt zurückgeführt wird, so entsteht direkt im Innern der Streifenleitung ein in Fig. 3 angedeutetes Magnetfeld. Da die Impedanz des Gehäuses 1 der Streifenleitung sehr gering ist, wird zweckmäßigerweise ein Transformator 9 verwendet, der den hohen Vormagnetisierungsstrom auf dem Gehäuse 1 (bis zu 1000 A) auf einen geeigneten Strom i (t) auf der Primärseite übersetzt. Die sekundärseitigen Anschlüsse des Transformators 9 sind mit den Kurzschlußplattenabschnitten kontaktiert, welche jeweils Innen- und Außenleiter der äußeren Streifenleitungsabschnitte miteinander verbinden (s. Fig. 2).

In dem beschriebenen Ausführungsbeispiel weist die Streifenleitung 1, 2 zwei Schlitze 7, 8 auf. Schon ein einziger Schlitz reicht aus, um die Streifenleitung in zwei Abschnitte für den Hin- und Rückweg des Stromes zu unterteilen. Unter gewissen Umständen, z.B. um eine besondere Charakteristik des Vormagnetfeldes zu realisieren, ist es angebracht, mehr als nur zwei Strompfade zu bilden. Dann sind auch mehr als zwei Schlitze erforderlich.

Die Fig. 4 zeigt einen Querschnitt durch eine geschlitzte Streifenleitung 1, 2 für die mehrere Vormagnetisierungssysteme vorhanden sind. Zum einen der schon erwähnte Permanentmagnet, bestehend aus zwei Einzelmagneten 10 und 11, zwischen denen die Streifenleitung so angeordnet ist, daß das statische Magnetfeld senkrecht auf den mit Ferrit 3 belegten Ebenen des Innenleiters 2 und/oder Außenleiters 1 steht. Zum anderen ist die oben beschriebene Anordnung vorhanden mit der im Innern der Streifenleitung ein mit hoher Frequenz (1 kHz - 100 kHz) veränderbares Vormagnetisierungsfeld erzeugt werden kann. Außerdem gibt es noch einen Elektromagneten, der ein mit geringer Frequenz (bis 1 kHz) veränderbares Vormagnetisierungsfeld erzeugt, das durch das Streifenleitungsgehäuse 1 in das Ferrit 3 eindringt. Dieser Elektromagnet besteht in bekannter Weise aus zwei Spulen 12, 13 die auf zwei Eisenkerne 14, 15 aufgewickelt sind. Der magnetische Luftspalt für den Elektromagneten wird durch den Abstand zwischen den beiden Eisenkernen 14, 15 definiert. Das Streufeld dieser Magnetanordnung kann dadurch gering gehalten werden, daß außerhalb des Luftspalts ein magnetischer Rückschluß 16, 17 aus Weicheisen verwendet wird.

Der von einem Abstimm-Verstärker kommende Strom für das Vormagnetisierungssystem kann mit Hilfe von Hoch-/Tiefpaß-Schaltungen in einen niederfrequenten Strom für den Elektromagneten und in einen höherfrequenten Strom für die geschlitzte Streifenleitung aufgeteilt werden.

## Patentansprüche

1. Streifenleitung, deren elektrische Länge mit Hilfe eines variablen Vormagnetisierungsfeldes abstimmbar ist, das auf Ferrit einwirkt, mit dem ein streifenförmiger Innenleiter und/oder ein diesen umgebender Außenleiter zumindest teilweise belegt ist, dadurch gekennzeichnet,
daß Außen- (1) und Innenleiter (2) durch einen oder mehrere in Wellenausbreitungsrichtung verlaufende Schlitze (8) in mindestens zwei Streifenleitungsabschnitte zerteilt sind, so daß ein über einen der Streifenleitungsabschnitte eingespeister und über einen anderen Streifenleitungsabschnitt rückgeführter veränderbarer Strom ein sich änderndes Vormagnetisierungsfeld im Innern der Streifenleitung erzeugt.

2. Streifenleitung nach Anspruch 1, dadurch gekennzeichnet, daß der veränderbare Strom über einen Transformator (9) an den Außen- (1) und Innenleiter (2) der Streifenleitungsabschsnitte angekoppelt ist.

3. Streifenleitung nach Anspruch 1, dadurch gekennzeichnet, daß sie von einem Elektromagneten (12 ... 17) umgeben ist, der ein von Außen in das Innere der Streifenleitung eindringendes Vormagnetisierungsfeld erzeugt, dessen Änderungsgeschwindigkeit geringer ist als die des Vormagnetisierungsfeldes, welches von einem den Außen- (1) und Innenleiter (2) durchfließenden Strom hervorgerufen wird.

4. Streifenleitung nach den Ansprüchen 1 und 3, dadurch gekennzeichnet, daß der niederfrequente Strom für den das Vormagnetisierungsfeld mit der geringeren Änderungsgeschwindigkeit erzeugenden Elektromagneten (12...17) von dem das Vormagnetisierungsfeld mit der höheren Änderungsgeschwindigkeit hervorrufenden höherfrequenten Strom durch Hoch- und Tiefpaß-Filterung getrennt ist.

5. Streifenleitung nach Anspruch 1, dadurch gekennzeichnet, daß ein Permanentmagnet (10, 11) vorhanden ist, der das Ferrit (3) in der Streifenleitung (1, 2) bis zur Sättigung vormagnetisiert.

## Claims

1. Strip conductor, the electrical length of which is tunable with the aid of a variable premagnetisation field, which acts on ferrite, with which a strip-shaped inner conductor and/or an outer conductor surrounding this is at least partly covered, characterised thereby that the outer conductor (1) and inner conductor (2) are divided up into at least two strip conductor portions by one or more slots (8) extending in wave propagation direction, so that a variable current fed by way of one of the strip conductor portions and returned by another strip conductor portion generates a varying premagnetisation field in the interior of the strip conductor.

2. Strip conductor according to claim 1, characterised thereby that the variable current is coupled by way of a transformer (9) to the outer conductor (1) and inner conductor (2) of the strip conductor portions.

3. Strip conductor according to claim 1, characterised thereby that it is surrounded by an electromagnet (12...17), which generates a premagnetisation field which penetrates from the outside into the interior of the strip conductor and the rate of change of which is lower than that of the premagnetisation field which is caused by a current flowing through the outer conductor (1) and inner conductor (2).

4. Strip conductor according to claims 1 and 3, characterised thereby that the low-frequency current for the electromagnet (12...17) producing the premagnetisation field with the lower rate of change is separated by high-pass and low-pass filtering from the high-frequency current causing the premagnetisation field with the higher rate of change.

5. Strip conductor according to claim 1, characterised thereby that a permanent magnet (10, 11), which premagnetises the ferrite (3) in the strip conductor (1, 2) until saturated, is present.

## Revendications

1. Ligne à bandes dont on peut accorder la longueur électrique à l'aide d'un champ de prémagnétisation variable qui agit sur des ferrites dont est au moins partiellement garni un conducteur intérieur en forme de bande et/ou un conducteur extérieur qui l'entoure, caractérisée
par le fait que le conducteur extérieur (1) et le conducteur intérieur (2) sont divisés, par une ou plusieurs fentes (8) orientées selon la direction de propagation des ondes, en au moins deux portions de lignes à bandes de façon qu'un courant variable amené par l'une des portions de la ligne à bandes et repartant par une autre portion de la ligne à bandes produise un champ de prémagnétisation variable à l'intérieur de la ligne à bandes.

2. Ligne à bandes selon la revendication 1, caractérisée par le fait que le courant variable est couplé, par l'intermédiaire d'un transformateur (9), aux conducteurs extérieurs (1) et aux conducteurs intérieurs (2) des portions de la ligne à bandes.

3. Ligne à bandes selon la revendication i, caractérisée par le fait qu'elle est entourée d'un électro-aimant (12 ... 17) qui produit un champ de prémagnétisation qui pénètre, de l'extérieur, dans l'intérieur de la ligne à bandes et dont la vitesse de variation est inférieure à celle du champ de prémagnétisation provoqué par un courant passant par les conducteurs extérieurs (1) et intérieurs (2).

4. Ligne à bandes selon les revendications 1 et 3, caractérisée par le fait que le courant basse fréquence pour l'électro-aimant (12...17) produisant le champ de prémagnétisation de plus faible vitesse de variation est séparé d'avec le courant de fréquence plus élevée qui provoque le champ de prémagnétisation de vitesse de variation plus élevée.

5. Ligne à bandes selon la revendication 1, caractérisée par le fait qu'il y a un aimant permanent (10. 11) qui prémagnétise jusqu'à la saturation les ferrites (3) qui sont dans la ligne à bandes (1, 2).
